(19) **Europäisches Patentamt / European Patent Office / Office européen des brevets**

(11)  **EP 2 656 006 B1**

(12)  # FASCICULE DE BREVET EUROPEEN

(45) Date de publication et mention
de la délivrance du brevet:
**01.07.2015 Bulletin 2015/27**

(21) Numéro de dépôt: **11815479.8**

(22) Date de dépôt: **20.12.2011**

(51) Int Cl.:
***G01C 19/56*** (2012.01)

(86) Numéro de dépôt international:
**PCT/FR2011/053103**

(87) Numéro de publication internationale:
**WO 2012/085456 (28.06.2012 Gazette 2012/26)**

(54) **STRUCTURE PLANAIRE POUR GYROMÈTRE TRI-AXE**

PLANARE STRUKTUR FÜR EIN DREIACHSIGES GYROMETER

PLANAR STRUCTURE FOR A TRIAXIAL GYROMETER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.12.2010 FR 1004967**

(43) Date de publication de la demande:
**30.10.2013 Bulletin 2013/44**

(73) Titulaire: **ONERA (Office National d'Etudes et de
Recherches
Aérospatiales)
92320 Châtillon (FR)**

(72) Inventeurs:
 • **ROLAND, Iännis
  F-92110 Clichy (FR)**
 • **MASSON, Stève
  F-92350 Le Plessis Robinson (FR)**
 • **DUCLOUX, Olivier
  F-71200 Le Creusot (FR)**

(74) Mandataire: **Cabinet Plasseraud
52, rue de la Victoire
75440 Paris Cedex 09 (FR)**

(56) Documents cités:
**WO-A1-98/17973    US-A1- 2010 236 327
US-B1- 6 539 804**

## Description

L'invention concerne un capteur inertiel. En particulier, l'invention se rapporte à un capteur inertiel remplissant la fonction de gyromètre vibrant à effet Coriolis et permettant de mesurer une information de rotation selon trois axes orthogonaux. Cette information est la vitesse de rotation du véhicule par rapport à chaque axe.

Un tel capteur inertiel est utilisé par exemple pour répondre aux besoins de contrôle d'attitude d'un véhicule. De plus, il est parfois combiné avec des accéléromètres pour confectionner une centrale inertielle dite 6-axes d'aide à la navigation et au pilotage d'un véhicule, et éventuellement combiné avec des magnétomètres pour réaliser une centrale inertielle 9-axes pour permettre en outre l'orientation du véhicule par rapport au champ magnétique terrestre.

Un gyromètre à effet Coriolis (« Coriolis Vibrating Gyroscope » CVG) comprend un élément sensible propre à vibrer selon au moins un mode de vibration primaire, lorsqu'il est excité par un dispositif d'excitation. Un tel capteur possède un ou plusieurs axes particuliers appelés « axes sensibles », caractérisés en ce que, lorsque le capteur inertiel est mis en rotation autour d'un axe de rotation instantané quelconque et lorsque son élément sensible vibre selon un mode de vibration primaire, alors ledit élément sensible vibre par effet Coriolis, selon un mode de vibration secondaire avec une amplitude proportionnelle à la projection du vecteur de rotation instantané sur ledit axe sensible. Ledit mode de vibration secondaire est propre à la géométrie de l'élément sensible, au mode de vibration primaire et à l'axe sensible considéré. L'amplitude de vibration de chaque mode secondaire est mesurée, par un dispositif de détection, pour déterminer la projection de la vitesse de rotation du véhicule sur l'axe sensible associé audit mode de vibration secondaire.

Le principe des gyromètres CVG est un concept particulièrement propice à la miniaturisation et, par conséquent, est particulièrement employé pour la réalisation de gyromètres de type microsystème électromécanique (« MicroElectroMechanicalSystem » MEMS), étant considéré qu'on appelle microsystème électromécanique un dispositif mécanique comportant une ou plusieurs parties mobiles, dont au moins une dimension est inférieure au millimètre et dont la réalisation est effectuée par des moyens technologiques classiquement employés dans le domaine de l'électronique et des microtechnologies.

Les gyromètres CVG de type MEMS sont ainsi particulièrement adaptés pour répondre à des applications nécessitant des dispositifs de dimensions réduites, tels que les applications spatiales, le guidage et le pilotage des drones, ...

Toutefois, un inconvénient fréquent des capteurs inertiels CVG est l'apparition sur les dispositifs de détection d'un signal additionnel, qui n'est représentatif que de la seule vibration primaire et non de la vitesse de rotation à mesurer. Ce signal additionnel est préjudiciable au bon fonctionnement du gyromètre car il dégrade la qualité de la mesure. Il est alors nécessaire d'implémenter sur les gyromètres CVG existants un traitement électronique complexe pour éliminer ce signal additionnel et obtenir la mesure de la vitesse de rotation.

L'origine de ce signal additionnel peut être liée à de multiples phénomènes physiques de natures différentes. L'un de ces phénomènes, bien connu de l'homme de l'art, est appelé communément « couplage mécanique ». Il s'agit d'un couplage malencontreux entre les modes de vibration secondaires et le ou les modes de vibration primaires, à cause duquel la vibration primaire induit un mouvement vibratoire selon les modes de vibration secondaires et inversement. Le couplage mécanique entraîne alors l'apparition d'un signal additionnel dans le système de détection, et cela même en l'absence de rotation du gyromètre.

L'origine du signal additionnel peut également être liée à un défaut de sélectivité du dispositif de détection. En effet, il est fréquent que les dispositifs de détection propres à détecter des vibrations secondaires soient également aptes à détecter, même avec une faible sensibilité, la vibration du mode de vibration primaire. Il en résulte l'apparition d'un signal additionnel dans le système de détection, en l'absence de rotation du gyromètre, qu'il est nécessaire de traiter électroniquement et qui dégrade la qualité des mesures de vitesses de rotation.

L'apparition d'un tel signal additionnel est un défaut récurrent dans l'état de l'art que l'invention vise à surmonter.

La plupart des gyromètres à effet Coriolis existants sont monoaxes, c'est-à-dire qu'ils mesurent la rotation par rapport à un unique axe sensible. Un exemple de gyromètre CVG monoaxe exploitant les vibrations d'une structure plane de diapason en quartz est décrit dans le brevet FR 2 789 171. Afin de caractériser le mouvement d'un véhicule, il est alors nécessaire d'utiliser un assemblage d'au moins trois gyromètres monoaxes pour déterminer une information de rotation selon les trois degrés de liberté en rotation du véhicule.

Une famille particulière de CVG regroupe les gyromètres biaxes vibrants à effet Coriolis (« Coriolis Vibrating Gyroscope » CVG) monolithiques. L'utilisation d'un tel capteur inertiel permet d'obtenir avec un unique dispositif des informations de rotation d'un véhicule selon deux axes. Toutefois, de manière analogue aux gyromètres à effet Coriolis monoaxes, il est nécessaire d'utiliser un assemblage d'au moins un gyromètre CVG monoaxe et d'un gyromètre CVG biaxe pour déterminer une information de rotation selon les trois degrés de liberté en rotation du véhicule.

Un exemple de cette famille de capteur inertiel, réalisé en tôle pliée, est décrit dans US 6 539 804. Dans l'exemple cité, la structure du gyromètre est composée, entre autres, d'un anneau vibrant, et de quatre masses indéformables reliées à la face supérieure de l'anneau par des éléments de couplage. Dans le fonctionnement présenté, le mode de vibration secondaire correspond à des mouvements hors-plan des masses, et le système de détection des modes secondaires s'appuie sur l'évaluation des contraintes engendrées dans les éléments de couplage par les mouvements hors-plan des masses en utilisant des céramiques piézoélectriques rapportées à la surface desdits éléments de coulage. Le mode de vibration primaire est une déformation de l'anneau qui vise à faire vibrer radialement les masses ; cependant, comme les masses sont situées en face supérieure de l'anneau, la mise en mouvement radiale des masses s'accompagne nécessairement d'un mouvement hors-plan similaire à la vibration des modes secondaires. Ceci engendre donc un couplage mécanique entre le mode de vibration primaire et le mode de vibration secondaire qui induit un signal additionnel sur le dispositif de détection et dégrade la mesure de la vitesse de rotation.

En outre, le procédé de réalisation de l'exemple cité est basé sur une découpe à l'emporte-pièce et le pliage d'une tôle d'acier, ce qui n'est pas compatible avec les technologies MEMS et n'est de ce fait pas favorable à la miniaturisation.

Une autre famille particulière de gyromètres CVG regroupe les gyromètres CVG triaxes monolithiques. L'utilisation d'un tel capteur inertiel permet d'obtenir avec un unique dispositif des informations de rotation d'un véhicule selon trois axes, de s'affranchir de l'étape d'assemblage des capteurs inertiels monoaxes et biaxes, et ainsi de gagner en compacité.

Un tel capteur inertiel triaxe nécessite la conception d'une structure excitée par un ou plusieurs modes de vibration primaires couplés par effet Coriolis à au moins trois modes de vibrations secondaires différents. A titre d'exemple, le document FR 2 821 422 présente la possibilité de confectionner une structure monolithique planaire de gyromètre triaxe en associant de manière monolithique deux sous-éléments planaires : l'un des sous-éléments est une structure planaire de gyromètre monoaxe plan ayant un axe sensible hors-plan (axe Z) et l'autre sous-élément est une structure planaire de gyromètre biaxe, inspirée du document FR 2 741 151, ayant ses deux axes sensibles dans le plan du substrat (axes X et Y). Le fonctionnement d'un tel gyromètre nécessite alors l'excitation du mode de vibration primaire de chacun des sous-éléments et nécessite par conséquent l'utilisation de deux dispositifs d'excitation distincts. Ceci conduit à des systèmes électroniques d'excitation pouvant être complexes et encombrants.

Afin de limiter l'encombrement, la complexité et la consommation électrique du dispositif d'excitation d'un capteur inertiel de la famille CVG triaxe, il est intéressant de n'utiliser qu'un seul mode de vibration primaire et que ce mode de vibration primaire soit couplé à chacun des trois modes de vibration secondaires.

Le brevet WO 98 17973 décrit un gyromètre CVG triaxe monolithique, compatible avec les technologies MEMS et utilisant un unique mode de vibration primaire. Toutefois, ce gyromètre utilise un même système d'électrodes pour détecter à la fois les amplitudes de vibration du mode primaire et de deux de ses modes de vibrations secondaires (correspondant aux axes X et Y). De ce fait, il présente, par principe de conception, un défaut de sélectivité des dispositifs de détection, si bien que les signaux électriques représentatifs de l'information de rotation selon les axes X et Y sont non seulement additionnés entre eux mais sont également additionnés à un signal électrique additionnel représentatif de la vibration du mode. Il est alors nécessaire d'implémenter un traitement électronique complexe des signaux issus desdites électrodes pour éliminer ce signal additionnel issu du mode de vibration primaire et séparer les informations représentatives des vitesses de rotation selon les deux axes sensibles X et Y.

Le brevet US 2010/0236327 A1 décrit un gyromètre triaxe monolithique compatible avec les technologies MEMS et n'utilisant qu'un seul mode de vibration primaire. Ce gyromètre présente un défaut de sélectivité des systèmes de détection. En effet, dans ce dispositif, le mode de vibration secondaire correspondant à la rotation selon l'axe X correspond à un mouvement hors-plan des masses 22 et 26. L'amplitude de ce mouvement est détectée par mesure de la variation des valeurs des capacités 82 et 86. Cependant, d'après les lois de la physique, les valeurs des capacités 82 et 86 sont également légèrement sensibles aux déplacements dans le plan des masses 22 et 26 induit par le mouvement primaire. Les valeurs de ces capacités 82 et 86 sont également sensibles aux rotations des mêmes masses 22 et 26 au cours de la vibration secondaire correspondant à la rotation selon l'axe Z. Il en résulte que le signal électrique représentatif de l'information de rotation selon l'axe X est additionné à des signaux électriques additionnels représentatifs de la vibration du mode primaire et du mode de vibration secondaire Z. Il est alors nécessaire d'implémenter un traitement électronique complexe des signaux pour séparer l'information représentative de la vitesse de rotation selon l'axe X des signaux additionnels parasites issus du mode de vibration primaire et du mode de vibration secondaire Z.

De plus, afin de garantir des mesures de vitesses de rotation avec la même précision selon les trois axes, il est important que les sensibilités de gyromètres soient sensiblement identiques selon les 3 axes sensibles. A cet effet, un coefficient de couplage par effet Coriolis est défini. Il représente la capacité d'un élément sensible à vibrer selon un mode de vibration secondaire par effet Coriolis lorsqu'il est excité dans un mode de vibration primaire et qu'il est mis en rotation autour de l'axe sensible associé audit mode de vibration secondaire. Le coefficient de couplage par effet Coriolis peut alors être quantifié par la relation suivante :

$$K = \left\| \frac{1}{V} \iiint\limits_{V} \vec{u}_{pilote} \wedge \vec{u}_{détection} \right\|$$

Dans laquelle $\vec{u}_{pilote}$ est le vecteur déplacement qui caractérise la vibration du mode primaire, $\vec{u}_{détection}$ est le vecteur déplacement qui caractérise la vibration du mode secondaire,
V est le volume de la structure.

L'obtention de 3 sensibilités équivalentes pour le gyromètre triaxe implique l'utilisation d'une structure vibrante dont les coefficients de couplage Coriolis sont sensiblement identiques pour les 3 axes sensibles. Un gyromètre ayant une sensibilité selon un axe très supérieure à sa sensibilité selon un autre axe ne pourrait pas réellement être utilisé pour déterminer de façon satisfaisante une information de rotation selon ses trois axes sensibles.

La présente invention permet de surmonter les difficultés énoncés dans l'art antérieur en proposant une structure de gyromètre CVG monolithique triaxe dont d'une part les coefficients de couplage par effet Coriolis sont sensiblement identiques selon ses différents axes sensibles, et dont d'autre part, les modes de vibrations secondaires sont préservés de l'influence du mode de vibration primaire.

A cet effet, l'invention a pour objet un capteur inertiel apte à mesurer une information de rotation selon trois axes orthogonaux (X, Y, Z) ; ledit capteur inertiel comprenant un support et un élément sensible solidaire du support ; ledit élément sensible étant propre à vibrer par rapport au support dans un mode de vibration primaire lorsqu'il est excité par un dispositif d'excitation, et dans des modes de vibration secondaires induits par une force de Coriolis, lorsque le capteur inertiel est déplacé autour d'un axe et que l'élément sensible est excité par un dispositif d'excitation ; ledit élément sensible comportant un cadre déformable qui s'étend dans un plan (X-Y) et au moins deux saillies déformables qui s'étendent dans le même plan (X-Y).

Lesdites au moins deux saillies déformables sont longilignes ; chacune de ces dites saillies déformables étant reliées uniquement par une de leurs extrémités au cadre déformable, de sorte que, dans le mode de vibration primaire, chacune desdites saillies déformables est translatée selon son axe longitudinal sans déformation ni contrainte, et que les coefficients de couplage par effet Coriolis entre le mode de vibration primaire et chacun des modes de vibration secondaires sont sensiblement égaux, ce grâce à quoi d'une part ledit capteur inertiel possède des sensibilités sensiblement égales pour mesurer les informations de rotation selon les trois axes orthogonaux (X, Y, Z), et d'autre part, les modes de vibration secondaires peuvent être insensibles à la vibration du mode de vibration primaire.

Les saillies étant translatées selon leur axe longitudinal sans contrainte ni déformation, le capteur inertiel est insensible à la vibration du mode de vibration primaire en l'absence de rotation.

Selon des modes particuliers de réalisation, le capteur inertiel comporte l'une ou plusieurs des caractéristiques suivantes :

- le capteur inertiel s'étend dans un même plan,
- chacune desdites saillies déformables comporte une extrémité qui est reliée au cadre déformable à un emplacement au niveau duquel l'amplitude du mode de vibration primaire est maximale,
- le support, le cadre déformable et les saillies déformables possèdent un plan de symétrie parallèle au plan formé par le cadre déformable et les saillies déformables,
- chaque saillie déformable comprend une poutre dont l'épaisseur selon la direction Z est sensiblement identique à l'épaisseur (selon la direction Z) du cadre déformable,
- le capteur inertiel comporte en outre une ou plusieurs attaches reliant le support au cadre déformable, lesdites attaches étant fixées sensiblement au niveau des noeuds de vibration des modes de vibration secondaires,
- les attaches comprennent chacune un bras d'attache relié au support et deux branches d'attache reliées au bras d'attache et au cadre déformable; chaque branche d'attache présentant une forme générale en L,
- le capteur inertiel comprend des zones de fixation reliées au support par des languettes de fixation flexibles,
- le capteur inertiel comporte en outre un dispositif de détection de chacun des modes de vibration secondaires ; ledit dispositif de détection exploitant un effet causé par la déformation des saillies déformables comme par exemple les effets piézoélectrique, piézorésistif, magnétostrictif et photoélectrique ; ce grâce à quoi ledit dispositif de détection est insensible à la vibration du mode de vibration primaire.
- au moins une face des saillies déformables comporte au moins deux électrodes de détection adjacentes qui s'étendent selon l'axe longitudinal des saillies déformables,
- ledit capteur inertiel est un microsystème électromécanique (MEMS).
- dont l'épaisseur selon l'axe Z est inférieure à 1 mm et de préférence inférieure à 500 μm,
- le capteur inertiel est monolithique,
- le capteur inertiel possède trois plans de symétrie selon (X, Y), (X, Z) et (Y, Z),
- le capteur inertiel comporte en outre des masses inertielles solidaires du cadre déformable (10) ; lesdites masses inertielles étant disposées sensiblement entre deux saillies déformables adjacentes,
- la section de chaque saillie augmente progressivement de son extrémité vers le cadre.

L'invention sera mieux comprise à la lecture de la description qui va suivre, donnée uniquement à titre d'exemple et faite en se référant aux dessins sur lesquels :

- la figure 1 est une vue schématique en perspective du capteur inertiel selon l'invention ;
- la figure 2 est une vue de face de la face supérieure du capteur inertiel selon l'invention ;
- la figure 3 est une vue de face de la face inférieure du capteur inertiel selon l'invention ;
- la figure 4 est une vue en perspective du capteur inertiel illustré sur la figure 1 lorsqu'il est excité selon le mode de vibration primaire ;
- la figure 5 est une vue en perspective de la déformée du mode de vibration secondaire du capteur inertiel de la figure 1 pour une vitesse de rotation appliquée selon l'axe sensible X ;
- la figure 6 est une vue en perspective de la déformée du mode de vibration secondaire du capteur inertiel de la figure 1 pour une vitesse de rotation appliquée selon l'axe sensible Y ;
- la figure 7 est une vue en perspective de la déformée du mode de vibration secondaire du capteur inertiel de la figure 1 pour une vitesse de rotation appliquée selon l'axe sensible Z ; et
- la figure 8 est une vue schématique en perspective d'une variante du capteur inertiel.

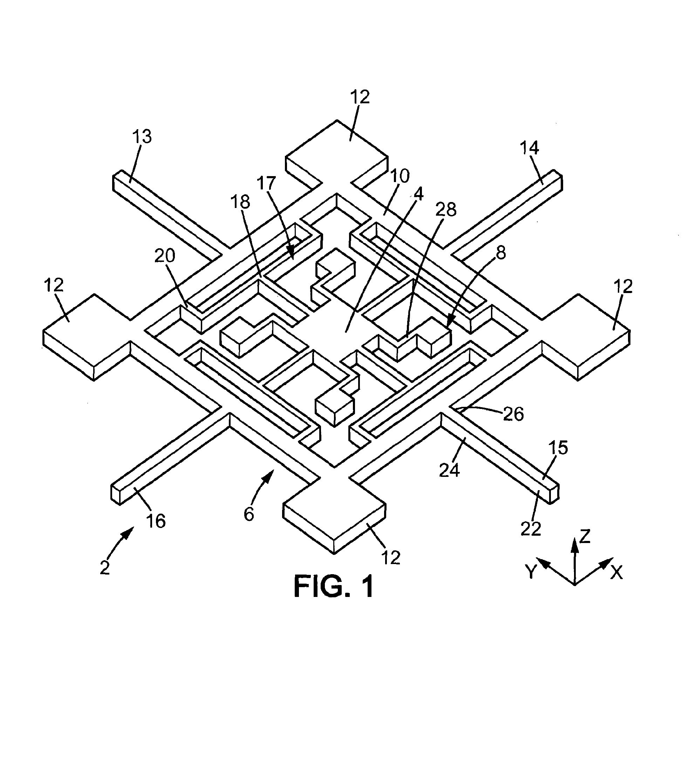

En référence à la figure 1, le capteur inertiel 2 comporte un support 4, un élément sensible 6 et des zones de fixation 8 portés par le support 4. Dans la configuration présentée à la figure 1, le support 4 est positionné au centre dudit capteur inertiel.

L'élément sensible 6 comprend un cadre déformable 10 de forme polygonale, en particulier de forme carrée, pourvu d'une masse inertielle 12 à chacun de ses coins, et de quatre saillies déformables 13, 14, 15, 16.

En variante, le cadre déformable 10 peut par exemple présenter une forme de rectangle, de losange ou de cercle.

Le support 4 et l'élément sensible 6 forment une structure plane qui s'étend dans un même plan (X, Y).

Les saillies déformables 13, 14, 15, 16 présentent une forme longiligne. Elles s'étendent dans le même plan (X, Y) que le cadre déformable 10 et le support 4.

Selon le mode de réalisation illustré sur la figure 1, les saillies déformables 13, 14, 15, 16 sont formées par des poutres qui présentent, par exemple, une épaisseur selon la direction Z sensiblement identique à l'épaisseur du cadre déformable 10.

Les axes longitudinaux desdites au moins deux saillies déformables 13, 14 ; 15, 16 sont non colinéaires et préférentiellement sensiblement orthogonaux.

Comme visible sur la figure 1, les saillies déformables 13, 14, 15, 16 ont une extrémité libre 22 et une extrémité liée 24 attachée au cadre déformable 10 à un emplacement au niveau duquel l'amplitude de vibration du mode de vibration primaire est maximale.

Par exemple, dans le mode de réalisation illustré sur la figure 1, l'extrémité liée 24 de chaque saillie déformable est attachée sensiblement au milieu de chaque côté du cadre déformable 10 à équidistance de deux masses inertielles adjacentes 12.

L'extrémité liée 24 des saillies déformables est fixée au cadre déformable 10 par une jointure 26.

Le support 4, le cadre déformable 10 et les saillies déformables 13, 14, 15, 16 forment une structure symétrique par rapport aux plans (X, Y), (X, Z) et (Y, Z) passant par le centre du support 4.

Le cadre déformable 10 est relié au support 4 par des attaches 17 autorisant la tenue et la déformation du cadre déformable 10.

Les quatre masses inertielles 12 présentent, par exemple, une forme carrée. Leur taille et leur masse ont été définies de manière à modifier l'inertie du cadre déformable 10 de sorte que le support 4 reste immobile lors de la déformation des modes de vibration secondaires, au cours des rotations autour des axes de rotation X et Y.

Les attaches 17 comprennent chacune un bras d'attache 18 relié au support 4 et deux branches d'attache 20 de forme générale en L. Chaque branche d'attache 20 est reliée, d'une part, au bras d'attache 18 et, d'autre part, au cadre déformable 10 à une position du cadre déformable 10 qui permet de minimiser la vibration du support 4 et ainsi de minimiser la fuite d'énergie vibratoire par les zones de fixation 8.

En particulier, les branches d'attache 20 sont reliées au cadre déformable 10 sensiblement au niveau des noeuds de vibration des modes de vibration secondaires du capteur inertiel. Dans le mode de réalisation représenté, chacune des branches d'attache 20 est reliées au cadre déformable 10 à un emplacement disposé entre une des masses inertielles 12 et une des saillies déformables 13, 14, 15, 16 adjacente à ladite masse inertielle.

Les zones de fixation 8 sont reliées au support 4 par des languettes de fixation flexible 28. Les languettes de fixation 28 sont, de préférence, coudées de manière à réaliser une suspension filtrante qui limite les fuites d'énergie vibratoire.

Les zones de fixation 8 présentent par exemple une forme carrée et s'étendent dans le plan (X, Y). Les faces inférieures de ces zones de fixation sont destinées à être collées au dispositif dont on souhaite mesurer l'angle, la vitesse ou l'accélération de rotation.

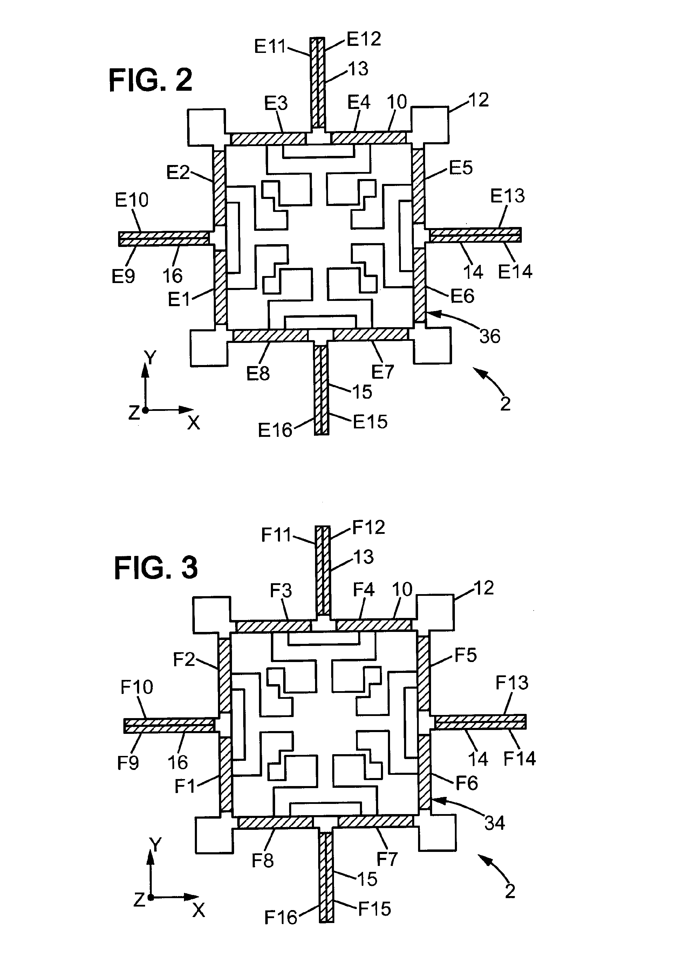

En référence aux figures 2 et 3, le capteur inertiel 2 selon l'invention comporte en outre des électrodes d'excitation et un générateur de tension connecté électriquement aux électrodes d'excitation pour faire vibrer l'élément sensible 6 dans le mode de vibration primaire, et des électrodes de détection reliées à une unité de traitement des signaux apte à calculer l'information de rotation selon les trois axes X, Y, Z à partir des signaux mesurés par les électrodes de détection.

Un exemple de disposition des électrodes d'excitation et des électrodes de détection est représenté sur les figures 2 et 3 pour un capteur inertiel réalisé dans un substrat d'arséniure de gallium découpé selon le plan cristallin de normale (100), et utilisant une méthode de détection et d'excitation piézoélectrique.

Selon cet exemple de réalisation, les électrodes d'excitation et les électrodes de détection sont constituées par des pistes métalliques E1 à E16 déposées sur une face, appelée face inférieure 36, et F1 à F16 déposées sur sa face opposée, appelée face supérieure 34.

En particulier, les électrodes d'excitation sont déposées sur les faces supérieure 34 et inférieure 36 du cadre déformable 10. Les électrodes de détection sont déposés sur les faces supérieure 34 et inférieure 36 des saillies déformables 13, 14, 15, 16.

Le capteur inertiel 2 est, par exemple, excité dans le mode de vibration primaire par application d'un potentiel électrique alternatif sur un groupe d'électrodes P1 comprenant les électrodes d'excitation référencées E1, E3, E5, E7, F2, F4, F6, F8, et un potentiel électrique alternatif différent sur un groupe d'électrodes P2 comprenant les électrodes d'excitation référencées E2, E4, E6, E8, F1, F3, F5, F7.

Des électrodes d'excitation d'un groupe d'électrodes sont disposées en vis-à-vis des électrodes d'excitation de l'autre groupe d'électrodes, et chaque côté du cadre déformable 10 comprend une électrode de chaque groupe d'électrodes. Les électrodes de détection sont disposées en vis-à-vis sur chacune des faces des saillies déformables 13, 14, 15 et 16 de sorte que chaque face des saillies déformables 13, 14, 15 et 16 comportent deux électrodes adjacentes qui s'étendent selon l'axe longitudinal desdites saillies déformables 13, 14,15 et 16.

Les fréquences des signaux électriques appliquées à chaque groupe d'électrodes d'excitation sont identiques et correspondent à la fréquence de résonance du mode de vibration primaire. Le dispositif d'excitation comprend un circuit électronique qui asservit l'excitation du mode de vibration primaire à sa fréquence de résonance.

L'information de rotation selon l'axe de rotation X est déterminée en soustrayant les charges recueillies sur un groupe d'électrodes DX1 comprenant les électrodes de détection référencées E11, E16, F11 et F16 aux charges recueillies sur un autre groupe d'électrodes DX2 comprenant les électrodes de détection référencées E12, E15, F12, F 15, par le biais d'un amplificateur de charge différentiel.

L'information de rotation selon l'axe Y est déterminée en soustrayant les charges recueillies sur un groupe d'électrodes DY1 comprenant les électrodes de détection référencées E9, E14 et F9, F14 aux charges recueillies sur un autre groupe d'électrodes DY2 comprenant les électrodes de détection référencées E10, E13, F10, F13, par le biais d'un amplificateur de charge différentiel.

L'information de rotation selon l'axe Z est déterminée en soustrayant les charges recueillies sur un groupe d'électrodes DZ1 comprenant les électrodes de détection référencées E9, E10, E11, E12, E13, E14, E15, E16 aux charges recueillies sur un autre groupe d'électrodes DZ2 comprenant les électrodes de détection référencées F9, F10, F11, F12, F13, F14, F15 et F16.

Plusieurs méthodes d'excitation de l'élément sensible 6, ainsi que plusieurs méthodes de détection de la vibration de celui-ci peuvent être envisagées en fonction du matériau utilisé pour la fabrication de l'élément sensible.

Une méthode d'excitation électrostatique peut par exemple être utilisée pour un élément sensible 6 fabriqué dans tout type de matériau. Une méthode d'excitation et de détection piézoélectrique peut être utilisée pour un élément sensible 6 réalisé dans du quartz, de l'arséniure de gallium, du nitrure de gallium, du nitrure d'aluminium, de l'oxyde de zinc, etc... Une méthode de détection capacitive peut être utilisée sur un élément sensible 6 réalisé dans tout type de matériau. De même, une méthode de détection optique peut être réalisée avec tout type de matériau. Enfin, une méthode de détection piézorésistive peut être réalisée lorsque l'élément sensible 6 est réalisé dans tout matériau présentant des propriétés piézorésistives tel que le silicium, l'arséniure de gallium, ...

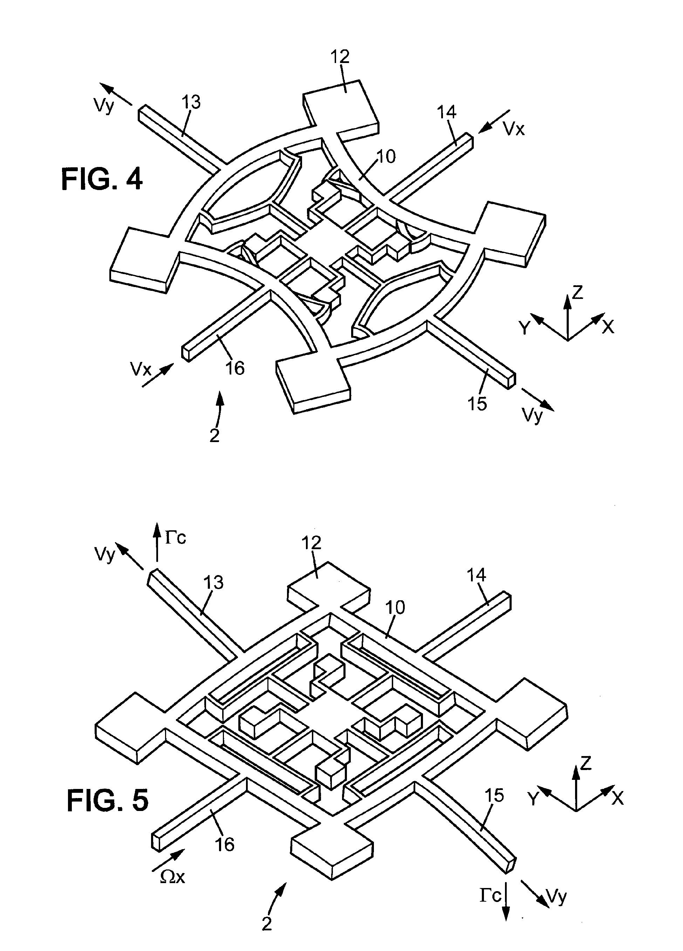

En référence à la figure 4, lorsque l'élément sensible 6, et en particulier le cadre déformable 10 dans l'exemple de réalisation représenté, est excité selon le mode de vibration primaire, les saillies déformables 13 et 15 sont animées d'un mouvement de translation Vy selon l'axe Y sans être déformées, comme visible sur la figure 4. De manière analogue, les saillies déformables 14 et 16 sont animées de mouvement de translation Vx selon l'axe X sans déformation.

Ainsi, lorsque l'élément sensible 6 est excité selon le mode de vibration primaire, chaque saillie déformable 13, 14, 15, 16 est translatée selon son axe longitudinal sans déformation ni contrainte. Cette translation pure des saillies déformables 13, 14, 15, 16 est assurée par l'existence d'un plan médian de symétrie de la structure 6. parallèle au plan (X, Y). En effet, si la position des saillies déformables était déportée vers l'une des faces du cadre déformable 10, comme cela est le cas dans US 6 539 804 B1, la mise en translation des saillies déformables 13, 14, 15, 16 s'accompagnerait nécessairement d'une déformation en flexion hors plan autour de la jointure 26 qui pourrait être assimilée par les systèmes de détection à l'une des vibrations secondaires et provoquerait ainsi une erreur dans la mesure de l'information de rotation. L'existence dudit plan de symétrie parallèle à (X, Y) évite cette flexion parasite. L'utilisation d'un système de détection exploitant la déformation des saillies déformables 13, 14, 15, 16 assure alors l'absence de signal sur les électrodes de détection (E9 à E16 et F9 à F16) en l'absence de rotation, et évite la superposition aux signaux de détection d'un signal électrique additionnel lié à la vibration primaire. Le système de détection peut exploiter des phénomènes physiques qui couplent la déformation d'un matériau à une autre grandeur électromagnétique ; ces phénomènes physiques peuvent être par exemple la piézoélectricité, la magnétostriction, la piézorésistivité, la photoélasticité, ...

En référence à la figure 5, lorsque l'élément sensible 6 est excité selon le mode de vibration primaire et que le capteur inertiel est pivoté autour de l'axe de rotation X avec une vitesse de rotation Ωx, l'effet Coriolis engendre sur les saillies déformables 13 et 15, des accélérations Γc orientées selon l'axe Z. L'effet Coriolis provoque ainsi une déformation en flexion hors plan (X, Y) des saillies déformables 13 et 15, comme visible sur la figure 5.

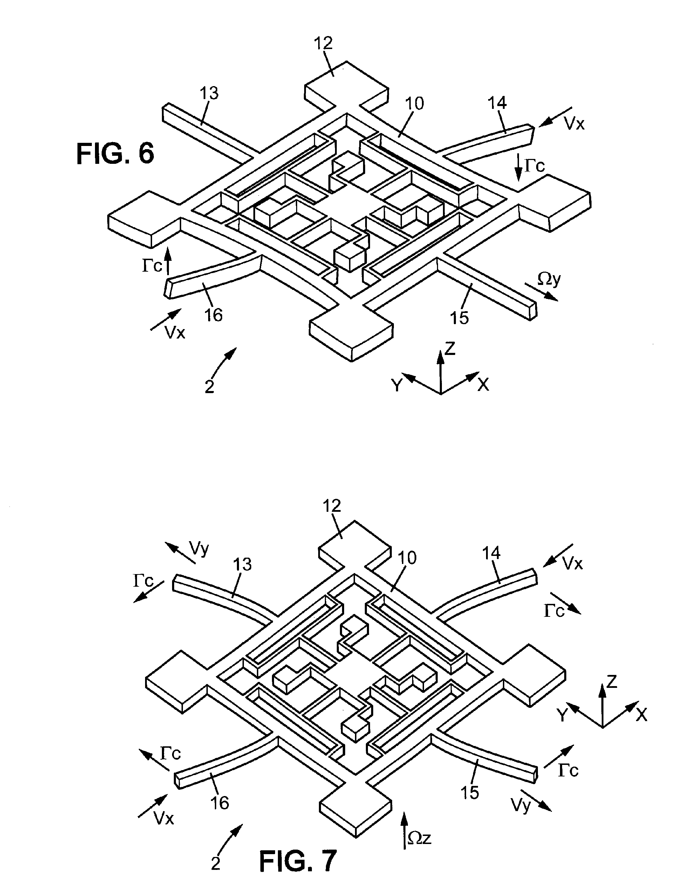

En référence à la figure 6, de manière analogue, lorsque l'élément sensible 6 est excité selon le mode de vibration primaire et que le capteur inertiel est pivoté autour de l'axe de rotation Y avec une vitesse de rotation Ωy, l'effet Coriolis engendre sur les saillies déformables 14 et 16 des accélérations Γc orientées selon l'axe Z. L'effet Coriolis provoque ainsi la flexion hors plan (X, Y) des saillies déformables 14 et 16, comme visible sur la figure 6.

En référence à la figure 7, lorsque l'élément sensible 6 est excité selon le mode de vibration primaire et que le capteur inertiel est pivoté autour de l'axe de rotation Z avec une vitesse de rotation Ωz, l'effet Coriolis engendre des accélérations Γc orientées selon l'axe X pour les saillies déformables 13 et 15 et orientées selon l'axe Y pour les saillies déformables 14 et 16. Les déformations ainsi obtenues par ces accélérations correspondent à une flexion de chacune des quatre saillies déformables dans le plan X-Y, comme représenté sur la figure 7.

Un dispositif de détection comprenant les électrodes de détection et l'unité de traitement des signaux est apte à détecter ces déformations et à calculer une information de rotation selon les trois axes X, Y, Z à partir de celles-ci.

Les coefficients de couplage par effet Coriolis entre le mode de vibration primaire et chacun des modes de vibration secondaires sont sensiblement égaux, de sorte que ledit capteur inertiel possède des sensibilités sensiblement égales pour mesurer les informations de rotation selon chacun desdits trois axes orthogonaux (X, Y, Z).

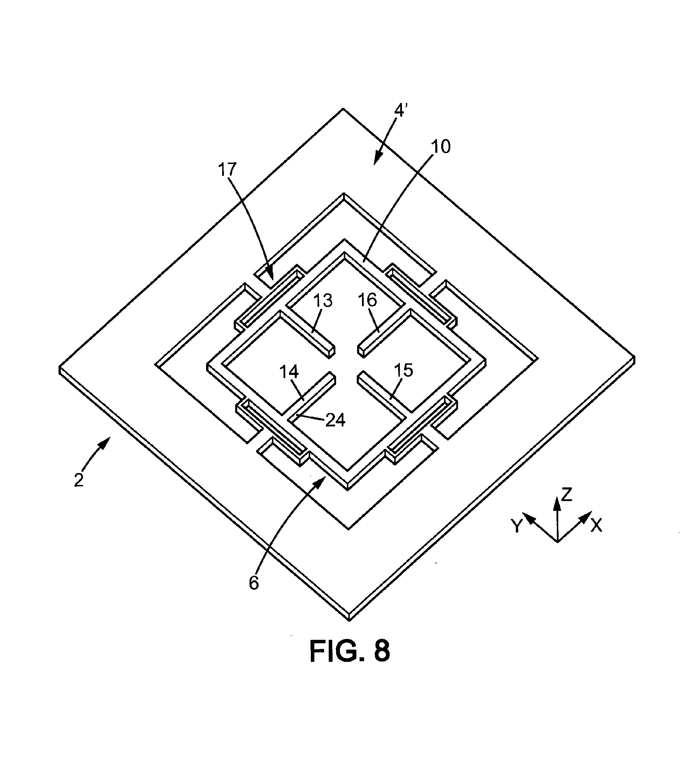

En référence à la figure 8, dans une variante de la configuration du capteur inertiel 2, le support 4' est disposé à l'extérieur du cadre déformable 10. En particulier, le support 4' est un cadre de forme polygonale. L'élément sensible 6 est alors situé à l'intérieur du support 4. Dans cette configuration, il n'y a pas de zones de fixation 8 ni de languettes de fixation 28. La masse du support 4', sensiblement plus grande que l'élément sensible 6, procure par effet d'inertie un découplage naturel des vibrations de l'élément sensible 6. Il est alors possible de coller l'une des faces du support 4' au dispositif dont on souhaite mesurer l'angle, la vitesse ou l'accélération de rotation, tout en limitant les fuites d'énergie vibratoire. Ainsi, le support 4' dans le dispositif de la figure 8 fait à la fois office de support 4, de zones de fixation 8 et de languettes de fixations 28 du dispositif illustré à la figure 1. Dans le cas d'une réalisation par des moyens technologiques associés aux MEMS, cette configuration autorise la tenue des structures par leur périphérie et facilite ainsi les opérations d'encapsulation sur tranche, afin de conditionner les capteurs inertiels de manière collective.

Dans un cas particulier de réalisation, le capteur inertiel 2 selon l'invention est avantageusement réalisé dans un matériau classiquement employé dans le domaine de l'électronique et de la micromécanique tel que, par exemple le silicium, un matériau semi-conducteur III-V (tels que l'arséniure de gallium, le nitrure de gallium, ou le phosphure d'indium, etc...), un matériau semi-conducteur II-VI (tel que l'oxyde de zinc, etc...), ou tout autre matériau ayant des propriétés piézoélectriques (tel que le quartz, l'orthophosphate de gallium, ou le niobate de lithium, etc...).

Dans un cas particulier de réalisation, le capteur inertiel 2 selon l'invention est avantageusement réalisé par gravure d'une plaque monolithique du matériau choisi, de forme plane et d'épaisseur constante. Une telle plaque est appelée substrat. En conséquence, le capteur inertiel 2 est monolithique et possède une forme sensiblement plane.

Dans un cas particulier de réalisation, le capteur inertiel 2 selon l'invention est réalisé dans un substrat dont l'épaisseur est typiquement inférieure à 1 mm et de préférence inférieure à 500 μm. En conséquence, la dimension mesurée selon l'axe Z des saillies déformable 13, 14, 15, 16, du cadre déformable 10 et du support 4 est inférieure à 1 mm, et de préférence inférieure à 500 μm.

Dans une configuration préférée, l'épaisseur hors-plan du dispositif est de 500 μm, la largeur dans le plan des saillies déformables est de 400 μm, la longueur des saillies déformables est de 3 mm. La largeur dans le plan de chacun des cotés du cadre déformable carré est de l'ordre de 5 mm.

Dans un cas particulier de réalisation, le capteur inertiel 2 selon l'invention est avantageusement un microsystème électromécanique (MEMS).

Avantageusement, le capteur inertiel est propre à être réalisé selon des procédés d'usinage collectifs utilisés pour les microsystèmes électromécaniques, tels que, par exemple, la photolithographie, la gravure chimique, la gravure ionique réactive, etc ....

Dans un cas particulier de réalisation, le capteur inertiel 2 forme une structure plane (X, Y) monoépaisseur.

Dans un cas particulier de réalisation, les saillies déformables 13, 14, 15, 16 présentent en outre une section sensiblement carrée, ce qui engendre avantageusement, de part leur forme longiligne, des coefficients de couplage par effet Coriolis entre le mode de vibration primaire et les modes de vibration secondaires sensiblement égaux.

Dans un cas particulier de réalisation, les sensibilités du dispositif selon les trois axes de détection

présent des valeurs maximales en raison du positionnement des saillies déformables sensiblement à l'emplacement ou l'amplitude de vibration du cadre déformable est la plus grande.

Dans un cas particulier de réalisation, le capteur inertiel 2 possède trois plans de symétrie selon (X, Y), (X, Z) et (Y, Z), ce qui permet avantageusement de découpler les vibrations des modes secondaires entre elles, de sorte qu'il y ait indépendance des vibrations des modes secondaires l'un de l'autre et qu'il n'est de ce fait pas nécessaire d'implémenter un traitement électronique complexe des signaux destiné à éliminer l'influence desdites vibrations parasites.

Avantageusement, le capteur inertiel comprend des masses inertielles et des languettes de fixation 28 disposées judicieusement permettant de découpler l'élément sensible vis-à-vis des zones de fixation 8 afin de limiter les fuites d'énergie vibratoire et de conserver des facteurs de qualité élevés pour chaque mode de vibration secondaire et le mode de vibration primaire, ce qui permet, entre autres choses, de limiter la consommation d'énergie électrique.

Dans un cas particulier de réalisation, la section de la jointure (26) s'élargit progressivement de la saillie 13, 14, 15, 16 vers le cadre 10 ; ceci ayant pour avantage de diminuer les contraintes dans la jointure (26) et diminue les risques de rupture, par exemple en fatigue.

Dans un cas particulier de réalisation, on combine une absence de masses inertielles et un positionnement des saillies déformables 13, 14, 15, 16 à des coins du cadre déformable 10.

## Revendications

1. Capteur inertiel (2) apte à mesurer une information de rotation selon trois axes orthogonaux (X, Y, Z) ; ledit capteur inertiel (2) comprenant un support (4, 4') et un élément sensible (6) solidaire du support (4, 4') ; ledit élément sensible (6) étant propre à vibrer par rapport au support (4, 4') dans un mode de vibration primaire lorsqu'il est excité par un dispositif d'excitation, et dans des modes de vibration secondaires induits par une force de Coriolis, lorsque le capteur inertiel (2) est déplacé autour d'un axe et que l'élément sensible (6) est excité par un dispositif d'excitation ; ledit élément sensible (6) comportant un cadre déformable (10) qui s'étend dans un plan (X-Y) et au moins deux saillies déformables (13, 14 ; 15, 16) qui s'étendent dans le même plan (X-Y) ; ledit mode de vibration primaire mettant en oeuvre une déformation du cadre déformable (10) lesdits modes de vibration secondaires mettant en oeuvre des déformation en flexion dans le plan ou hors-plan desdites au moins deux saillies déformables (13, 14; 15, 16) ; **caractérisé en ce que** :

   - chacune desdites au moins deux saillies déformables (13, 14 ; 15, 16) est une poutre de section sensiblement carrée; dont l'axe longitudinal est rectiligne ;
   - chacune desdites poutres (13, 14 ; 15, 16) étant reliées uniquement par l'une de ses extrémités (24) au cadre déformable (10), à un emplacement au niveau duquel l'amplitude du mode de vibration primaire est maximale, de sorte que, dans le mode de vibration primaire, chacune desdites poutres (13, 14; 15, 16) soit translatée selon son axe longitudinal
   - le capteur inertiel s'étend dans un même plan ;
   - le cadre déformable (10) et lesdites au moins deux saillies déformables (13, 14 ; 15, 16) possèdent un plan de symétrie parallèle au plan (X-Y), ce grâce à quoi la translation desdites au moins deux saillies déformables (13, 14 ; 15, 16) s'effectuent sans déformation ni contrainte ;
   - les axes longitudinaux desdites au moins deux saillies déformables (13, 14 ; 15, 16), selon lesquels ces dernières sont mises en translation par la vibration primaire, sont non colinéaires et préférentiellement sensiblement orthogonaux ;
   - il comporte en outre un dispositif de détection de chacun des modes de vibrations secondaires ; ledit dispositif de détection exploitant un effet causé par la déformation desdites poutres (13, 14, 15, 16) comme par exemple les effets piézoélectrique, piézorésistif, magnétostrictif et photoélectrique.

2. Capteur inertiel (2) selon la revendication 1, dans lequel l'épaisseur selon la direction Z de chacune des saillies déformables (13, 14, 15 16) est sensiblement identique à l'épaisseur selon la direction Z du cadre déformable (10).

3. Capteur inertiel (2) selon l'une quelconque des revendications précédentes, qui comporte en outre une ou plusieurs attaches (17) reliant le support (4) au cadre déformable (10), lesdites attaches (17) étant fixées sensiblement au niveau des noeuds de vibration des modes de vibration secondaires.

4. Capteur inertiel (2) selon la revendication précédente, dans lequel les attaches (17) comprennent chacune un bras d'attache (18) relié au support (4) et deux branches d'attache (20) reliées au bras d'attache (18) et au cadre déformable (10) ; chaque branche d'attache (20) présentant une forme générale en L.

5. Capteur inertiel (2) selon l'une quelconque des revendications précédentes, qui comprend des zones de fixation (8) reliés au support (4) par des languettes de fixation flexibles (28).

**6.** Capteur inertiel (2) selon l'une quelconque des revendications précédentes, qui est réalisé dans un matériau piézoélectrique tel que l'Arséniure de Gallium ; dans lequel le dispositif de détection de chacun des modes de vibration secondaires exploite des effets piézoélectriques du matériau; et dans lequel au moins une face (34, 36) des saillies déformables (13, 14, 15, 16) comporte au moins deux électrodes de détection adjacentes (E9, E10, E11, E12, E13, E14, E15, E16, F9, F10, F11, F12, F13, F14, F15, F16) qui s'étendent selon l'axe longitudinal des saillies déformables (13, 14, 15, 16).

**7.** Capteur inertiel (2) selon l'une quelconque des revendications précédentes, dans lequel ledit capteur inertiel (2) est un microsystème électromécanique.

**8.** Capteur inertiel (2) selon l'une quelconque des revendications précédentes, dont l'épaisseur selon l'axe Z est inférieure à 1 mm et de préférence inférieure à 500 $\mu$m.

**9.** Capteur inertiel (2) selon l'une quelconque des revendications précédentes, dans lequel ledit capteur inertiel (2) est monolithique.

**10.** Capteur inertiel (2) selon l'une quelconque des revendications précédentes, dans lequel le capteur inertiel (2) possède trois plans de symétrie selon (X-Y), (X-Z) et (Y-Z).

**11.** Capteur inertiel (2) selon l'une quelconque des revendications précédentes, qui comporte en outre des masses inertielles (12) solidaires du cadre déformable (10) ; lesdites masses inertielles (12) étant disposées sensiblement entre deux saillies déformables (13, 14, 15, 16) adjacentes.

**12.** Capteur inertiel (2) selon l'une quelconque des revendications précédentes, dont la section de chaque saillie (13, 14, 15, 16) augmente progressivement de son extrémité vers le cadre (10).

**Patentansprüche**

**1.** Trägheitssensor (2) zum Messen einer Rotationsinformation entlang dreier orthogonaler Achsen (X, Y, Z); wobei der Trägheitssensor (2) einen Träger (4, 4') und ein fest mit dem Träger (4, 4') verbundenes empfindliches Element (6) umfasst; wobei das empfindliche Element (6) geeignet ist, in Bezug auf den Träger (4, 4') in einem Primärvibrationsmodus zu vibrieren, wenn es durch eine Anregungsvorrichtung angeregt wird, und in Sekundärvibrationsmodi, die durch eine Corioliskraft induziert werden, zu vibrieren, wenn der Trägheitssensor (2) um eine Achse bewegt wird und das empfindliche Element (6) durch eine Anregungsvorrichtung angeregt wird; wobei das empfindliche Element (6) einen verformbaren Rahmen (10), der sich in einer Ebene (X-Y) erstreckt, und zumindest zwei verformbare Vorsprünge (13, 14; 15, 16), die sich in derselben Ebene (X-Y) erstrecken, aufweist; wobei der Primärvibrationsmodus eine Verformung des verformbaren Rahmens (10) bewirkt und die Sekundärvibrationsmodi Biegeverformungen in der Ebene oder außerhalb der Ebene der zumindest zwei verformbaren Vorsprünge (13, 14; 15, 16) bewirken;
**dadurch gekennzeichnet, dass**:

- jeder der zumindest zwei verformbaren Vorsprünge (13, 14; 15, 16) ein Balken mit im Wesentlichen quadratischem Querschnitt ist, dessen Längsachse geradlinig ist;
- jeder der Balken (13, 14; 15, 16) ausschließlich durch eines seiner Enden (24) an einer Stelle, an der die Amplitude des Primärvibrationsmodus maximal ist, mit dem verformbaren Rahmen (10) verbunden ist, sodass im Primärvibrationsmodus jeder der Balken (13, 14; 15, 16) entlang seiner Längsachse verschoben wird;
- sich der Trägheitssensor in einer selben Ebene erstreckt;
- der verformbare Rahmen (10) und die zumindest zwei verformbaren Vorsprünge (13, 14; 15, 16) eine zur Ebene (X-Y) parallele Symmetrieebene besitzen, wodurch die Verschiebungen der zumindest zwei verformbaren Vorsprünge (13, 14; 15, 16) ohne Verformung oder Beanspruchung erfolgen;
- die Längsachsen der zumindest zwei verformbaren Vorsprünge (13, 14; 15, 16), entlang derer diese durch die primäre Vibration verschoben werden, nicht kollinear und vorzugsweise im Wesentlichen orthogonal sind;
- er ferner eine Vorrichtung zur Erfassung jedes der Sekundärvibrationsmodi aufweist; wobei die Erfassungsvorrichtung einen durch die Verformung der Balken (13, 14; 15, 16) erzeugten Effekt, wie beispielsweise einen piezoelektrischen, piezoresistiven, magnetostriktiven oder photoelektrischen Effekt, nutzt.

**2.** Trägheitssensor (2) nach Anspruch 1, wobei die Dicke jedes der verformbaren Vorsprünge (13, 14, 15 16) entlang der Z-Richtung im Wesentlichen identisch mit der Dicke des verformbaren Rahmens (10) entlang der Z-Richtung ist.

**3.** Trägheitssensor (2) nach einem der vorangehenden Ansprüche, der ferner eine oder mehrere Halterungen (17) aufweist, die den Träger (4) mit dem verformbaren Rahmen (10) verbinden, wobei die Halterungen (17) im Wesentlichen im Bereich der Vibrationsknoten der Sekundärvibrationsmodi befestigt sind.

4. Trägheitssensor (2) nach dem vorangehenden Anspruch, wobei die Halterungen (17) jeweils einen mit dem Träger (4) verbundenen Halterungsarm (18) und zwei mit den Halterungsarmen (18) bzw. dem verformbaren Rahmen (10) verbundene Halterungsschenkel (20), die eine allgemeine L-Form aufweisen, umfassen.

5. Trägheitssensor (2) nach einem der vorangehenden Ansprüche, der Befestigungsbereiche (8) umfasst, die durch flexible Befestigungslaschen (28) mit dem Träger (4) verbunden sind.

6. Trägheitssensor (2) nach einem der vorangehenden Ansprüche, der in einem piezoelektrischen Material, wie Galliumarsenid, ausgeführt ist; wobei die Vorrichtung zur Erfassung jedes der Sekundärvibrationsmodi piezoelektrische Effekte des Materials nutzt; und wobei zumindest eine Seite (34, 36) der verformbaren Vorsprünge (13, 14, 15, 16) zumindest zwei benachbarte Erfassungselektroden (E9, E10, E11, E12, E13, E14, E15, E16, F9, F10, F11, F12, F13, F14, F15, F16) aufweist, die sich entlang der Längsachse der verformbaren Vorsprünge (13, 14, 15, 16) erstrecken.

7. Trägheitssensor (2) nach einem der vorangehenden Ansprüche, wobei der Trägheitssensor (2) ein elektromechanisches Mikrosystem ist.

8. Trägheitssensor (2) nach einem der vorangehenden Ansprüche, dessen Dicke entlang der Z-Achse kleiner als 1 mm und vorzugsweise kleiner als 500 $\mu$m ist.

9. Trägheitssensor (2) nach einem der vorangehenden Ansprüche, wobei der Trägheitssensor (2) monolithisch ist.

10. Trägheitssensor (2) nach einem der vorangehenden Ansprüche, wobei der Trägheitssensor (2) drei Symmetrieachsen entlang (X-Y), (X-Z) und (Y-Z) besitzt.

11. Trägheitssensor (2) nach einem der vorangehenden Ansprüche, der ferner fest mit dem verformbaren Rahmen (10) verbundene träge Massen (12) aufweist; wobei die trägen Massen (12) im Wesentlichen zwischen zwei benachbarten verformbaren Vorsprüngen (13, 14, 15, 16) angeordnet sind.

12. Trägheitssensor (2) nach einem der vorangehenden Ansprüche, wobei der Querschnitt jedes Vorsprungs (13, 14, 15, 16) von seinem Ende zum Rahmen (10) hin schrittweise zunimmt.

**Claims**

1. Inertial sensor (2) able to measure information relating to rotation in three (X, Y, Z) orthogonal axes; said inertial sensor (2) comprising a support (4, 4') and a sensitive element (6) secured to the support (4, 4'); said sensitive element (6) being adapted to vibrate relative to the support (4, 4') in a primary vibration mode when it is excited by an excitation device, and in secondary vibration modes induced by a Coriolis force, when the inertial sensor (2) is moved about an axis and the sensitive element (6) is excited by an excitation device; said sensitive element (6) comprising a deformable frame (10) which extends in a plane (X-Y) and at least two deformable projections (13, 14, 15, 16) which extend in the same plane (X-Y); said primary vibration mode implementing a deformation of the deformable frame (10); said secondary vibration modes implementing in-plane or out-of-plane bending deformations of said at least two deformable projections (13, 14, 15, 16); **characterized in that**:

  ■ each of said at least two deformable projections (13, 14, 15, 16) is a beam of a substantially square cross-section whose longitudinal axis is rectilinear;
  ■ each of said beams (13, 14, 15, 16) being connected only by one of its ends (24) to the deformable frame (10) at a location at which the amplitude of the primary vibration mode is at a maximum so that in the primary vibration mode, each of said beams (13, 14, 15, 16) is translated on its longitudinal axis;
  ■ the inertial sensor extends in one and the same plane;
  ■ the deformable frame (10) and said at least two deformable projections (13, 14, 15, 16) possess a plane of symmetry parallel to the (X-Y) plane, due to which the translation of said at least two deformable projections (13, 14, 15, 16) occurs without deformation or stress;
  ■ the longitudinal axes of said at least two deformable projections (13, 14, 15, 16), along which the latter are displaced by the primary vibration, are non-collinear and are preferably substantially orthogonal;
  ■ it further comprises a device for detecting each of the secondary vibration modes; said detection device exploiting an effect caused by the deformation of said beams (13, 14, 15, 16), such as for example magnetostrictive, piezoelectric, piezoresistive, and photoelectric effects.

2. Inertial sensor (2) according to claim 1, wherein the thickness in the Z direction of each of the deformable projections (13, 14, 15, 16) is substantially equal to the thickness in the Z direction of the deformable frame (10).

3. Inertial sensor (2) according to any one of the preceding claims, which further comprises one or a plurality of fasteners (17) connecting the support (4) to the deformable frame (10), said fasteners (17) being fixed substantially at the nodes of vibration of the secondary vibration modes.

4. Inertial sensor (2) according to the preceding claim, wherein the fasteners (17) each comprise a fastening arm (18) connected to the support (4) and two fastening legs (20) connected to the fastening arm (18) and to the deformable frame (10), each fastening leg (20) having a general L-shape.

5. Inertial sensor (2) according to any one of the preceding claims, comprising fastening areas (8) connected to the support (4) by flexible fastening tabs (28).

6. Inertial sensor (2) according to any one of the preceding claims, made from a piezoelectric material such as Gallium arsenide; wherein the device to detect each of the secondary vibration modes takes advantage of the piezoelectric effects of the material; and wherein at least one face (34, 36) of the deformable projections (13, 14, 15, 16) comprises at least two adjacent detection electrodes (E9, E10, E11, E12, E13, E14, E15, E16, F9, F10, F11, F12, F13, F14, F15, F16) which extend along the longitudinal axis of the deformable projections (13, 14, 15, 16).

7. Inertial sensor (2) according to any one of the preceding claims, wherein said inertial sensor (2) is a micro-electro-mechanical system.

8. Inertial sensor (2) according to any one of the preceding claims, wherein the thickness along the Z axis is less than 1mm and preferably less than 500$\mu$m.

9. Inertial sensor (2) according to any one of the preceding claims, wherein said inertial sensor (2) is monolithic.

10. Inertial sensor (2) according to any one of the preceding claims, wherein the inertial sensor (2) possesses three planes of symmetry along (X-Y), (X-Z) and (Y-Z).

11. Inertial sensor (2) according to any one of the preceding claims, further comprising inertial masses (12) secured to the deformable frame (10); said inertial masses (12) being placed substantially between two adjacent deformable projections (13, 14, 15, 16).

12. Inertial sensor (2) according to any one of the preceding claims, wherein the cross-section of each projection (13, 14, 15, 16) gradually increases from its end toward the frame (10).

**FIG. 1**

FIG. 2

FIG. 3

FIG. 4

12

Vy

13

14

Vx

10

Z

Y

X

Vx

16

15

Vy

2

FIG. 5

Γc

Vy

12

13

14

10

Z

Y

X

16

15

Γc

Vy

Ωx

2

FIG. 6

FIG. 7

**FIG. 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2789171
- US 6539804 B
- FR 2821422
- FR 2741151
- WO 9817973 A
- US 20100236327 A1
- US 6539804 B1